# EUROPEAN PATENT SPECIFICATION

(11) **EP 2 972 443 B1**
(45) Date of publication and mention of the grant of the patent: **17.01.2018**
(21) Application number: 14760850.9
(22) Date of filing: 05.03.2014
(51) Int. Cl.: G01R 33/3815, G01R 33/421

(54) **VERSATILE SUPERCONDUCTING MAGNET FOR EXTREMITIES MAGNETIC RESONANCE IMAGING**
FLEXIBEL VERWENDBARER SUPRALEITENDER MAGNET FÜR DIE MAGNETRESONANZBILDGEBUNG VON EXTREMITÄTEN
AIMANT SUPRACONDUCTEUR POLYVALENT POUR IMAGERIE À RÉSONANCE MAGNÉTIQUE D'EXTRÉMITÉS

(30) Priority: 06.03.2013 US 201361773472 P; 23.01.2014 US 201414161692
(43) Date of publication of application: 20.01.2016
(73) Proprietor: Pourrahimi, Shahin, Brookline, MA 02446 (US)
(72) Inventor: Pourrahimi, Shahin, Brookline, MA 02446 (US)
(74) Representative: Awapatent AB
(86) International application number: PCT/US2014/020883
(87) International publication number: WO 2014/138293

(56) References cited:
- EP-A1- 0 984 293
- US-A- 5 633 587
- US-A- 5 646 532
- US-A- 5 820 623
- US-A1- 2009 310 841
- US-B1- 6 396 377
- US-B1- 7 999 548
- 'AMI Superconducting Magnets: Installation, Operation, and Maintenance Instructions.' AMI 04 September 1996, pages 1 - 2, XP055284329 Retrieved from the Internet: <URL:http://www.americanmagnetics.com/suppo rt/manuals/magnets.pdf> [retrieved on 2014-05-28]

## Description

### TECHNICAL FIELD

This application relates generally to medical devices. More specifically, this application relates to a method and apparatus for extremities magnetic resonance imaging.

An apparatus of the aforementioned kind is known from US patent application 2009/31 08 41 A1 disclosing an extremities MRI device comprising a device body having a central opening bore configured to receive a body extremity to be scanned, and a superconducting field magnet. The device contains an indentation for receiving the other limb, while a first limb is arranged within the central opening bore.

### BRIEF DESCRIPTION OF THE DRAWINGS

The drawings, when considered in connection with the following description, are presented for the purpose of facilitating an understanding of the subject matter sought to be protected.
FIGURE 1 shows an example arrangement for using a conventional whole-body Magnetic Resonance Imaging (MRI) system for medical diagnostics;
FIGURE 2 shows an example arrangement for using an extremities MRI system for medical diagnostics usable with head and limbs of some patients;
FIGURE 3 shows an example arrangement for using a multi-bore extremities MRI system for medical diagnostics usable with head and limb of some patients;
FIGURE 4 shows a perspective cross-section A-A of the example arrangement for using a multi-bore extremities MRI system of FIGURE 3;
FIGURE 5 shows an example application of the multi-bore extremities MRI system of FIGURE 3 in a standing or vertical position; and
FIGURE 6 shows an example application of the multi-bore extremities MRI system of FIGURE 3 in a lying down or horizontal position.

### DETAILED DESCRIPTION

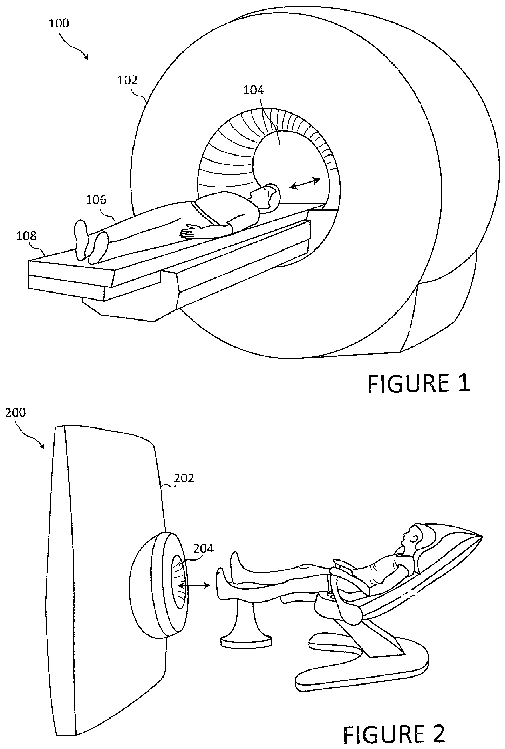

While the present disclosure is described with reference to several illustrative embodiments described herein, it should be clear that the present disclosure should not be limited to such embodiments. Therefore, the description of the embodiments provided herein is illustrative of the present disclosure and should not limit the scope of the invention as claimed. In addition, while the following description references application of multi-bore MRI system to human limbs, it will be appreciated that the disclosure may apply to other MRI applications such as human head, animal diagnostics and research, non-medical and/or industrial applications, and the like. An Extremities Magnetic Resonance Imaging device according to the invention comprises a device body having at least two bores deployed therein including a central scanning bore configured to receive a body extremity to be scanned, and a side scanning bore, wherein the central scanning bore and the side non-scanning bore are physically separate and isolated from each other and do not enclose a common space. A superconducting field magnet surrounds the scanning bore, and a shield magnet surrounds the superconducting field magnet, the central scanning bore, and the side non-scanning bore, wherein the side non-scanning bore is deployed between the superconducting field magnet and the shield magnet and is configured to receive a body extremity not to be scanned. The cross section of the extra bore may be circular, oval, or any other appropriate and useful geometric shape. The extra bore may or may not be parallel to the scanning bore. In various embodiments, the EMRI system may have a passively shielded superconducting magnet in which the other leg may be placed between the outside of a cryostat of the superconducting magnet and the ferromagnetic shield components. In various embodiments, the EMRI machine may be attached to an articulating arm to allow the easy adjustment of the position and orientation of the EMRI machine. A method in accordance with the invention is defined in claim 8. The other claims set out optional features. MRI is a technique for accurate and high-resolution visualization of interior of animal tissues. This technique is based on the nuclear magnetic resonance (NMR) property. MRI is often implemented in the form of a scanning device or scanner in which the patient lies horizontally within a scanning bore (see FIGURE 1) of sufficient size to accommodate the whole body of the patient. The scanning bore is surrounded by various devices including a magnet generating a powerful static magnetic field that surrounds the patient lying within the scanning bore. The static magnetic field aligns atomic nuclei in the patient's tissues in a particular direction. Then, Radio Frequency (RF) and gradient magnetic fields are applied to alter the alignment induced by the static field. The interference of the gradient fields with the static field causes the nuclei in the tissues to produce a rotating magnetic field detectable by the MRI scanner. Open MRI machines are also used for some applications in which patient is situated between two magnetic components, usually on top and bottom with open sides, instead of a cylindrical bore completely enclosing a section of the patient's body on all sides.

The MRI image is subsequently constructed with computer software based on the detected changes in the magnetic field. The magnetic field gradients thus applied cause nuclei in various tissues and locations within the body to precess (change in the orientation of the rotational axis of a rotating body) at different rates or speeds. The different precession rates allow spatial information needed to construct an image to be recovered from the measured signals using various mathematical techniques, such as Fourier analysis. By using gradient fields in different directions, two Dimensional (2D) images or 3D volumes can be obtained in any arbitrary orientation.

MRI in part uses the fact that body tissue contains a large proportion of water, and hence protons (Hydrogen nuclei), the orientation of which are aligned in a particular direction when placed within a large static magnetic field. Each water molecule has two hydrogen nuclei or protons. The average magnetic moment of many protons becomes aligned with the direction of the field. Gradient coils are used to produce a momentary RF current to generate a varying electromagnetic field with a resonance frequency, which changes or flips the spin of the protons. After the gradient coils are turned off, the gradient varying magnetic field disappears causing the spins of the protons to return to their original states and be re-aligned with the static magnetic field. This return to original spin state is called relaxation. During this relaxation, an RF signal is generated by the change in the spin, which can be measured by instruments such as receiver coils. Thus, 3D information about the origin of the signal in the body may be obtained by applying additional gradient magnetic fields. These additional gradient magnetic fields may be applied to generate signals only from specific locations in the body (spatial excitation) and/or to make magnetization at different spatial locations precess at different frequencies, which allows k-space (*k*-space is the 2D or 3D Fourier transform of the MR image) encoding of spatial information. The 3D images obtained in MRI can be rotated along arbitrary orientations and manipulated by the medical professional to detect changes of structures within the body.

Protons in different tissues return to their original equilibrium state within the static magnetic field at different relaxation rates. Different tissue variables, including spin density, various relaxation times, and flow and spectral shifts, can be used to construct images. By changing the settings on the scanner, contrast may be created between different types of body tissue. MRI may provide better contrast between the different soft tissues of the body, such as the organs, the brain, muscles, the heart, malignant tissues, and other soft tissues compared with other imaging techniques such as Computer Tomography (CT) or X-rays. MRI is also generally safer because unlike CT scan or X-ray, no ionizing radiation is used in MRI, and thus, it is safer from a radiation standpoint. As such, MRI scanners are often used for biomedical research and diagnosis of human disease and disorder.

Imaging by an MRI scanner requires a very uniform, constant, and stable magnetic field over a specific volume. Conventionally, such a magnetic field, often referred to as a B₀ field, is produced by a permanent or a superconducting magnet. For human applications, MRI devices that use permanent magnets typically generate a B₀ magnetic field of less than one Tesla (T). For higher resolution imaging, superconducting electromagnets producing higher magnetic fields are used. Typically, high resolution human MRI scanners use magnets that generate fields of 1 T or higher. Superconducting MRI magnets that generate a field of higher than 1 T have a cylindrical bore for equipment and patient access. Open MRI machines can also achieve 1 T, but become proportionally large, heavy, and expensive to buy, install, and operate. If the patient bore is large enough to allow for the whole human body to fit through the scanner, it is referred to as a whole body scanner. Such scanners are large and expensive. There are certain other smaller scanners that have smaller bores, allowing the extremities, arms and legs, to fit through. These scanners, referred to as extremities scanners, are smaller and less expensive but offer acceptable scanning over arms and legs. The magnetic fields of superconducting magnets with cylindrical bores are typically generated by a number of solenoid type superconducting coils within the overall superconducting magnet.

Superconducting B₀ magnets use coils that need to be maintained at cryogenic temperatures that are lower than the critical temperature of the superconducting coils to allow superconductor mode of the coil material to appear, in which electrical resistance is zero. To achieve this, conventionally, the coils of a superconducting MRI magnet operate in a pool of liquid helium, at close to atmospheric pressure, that keeps the coils at about 4.2 K.

An alternative to operating MRI superconducting coils in a pool of liquid helium is to cool the coils by a cryocooler that is physically connected to the coils by solid materials that conduct heat away from the coils. Conventionally, these types of magnets are called cryogen-free (CF) or conduction cooled magnets.

One of the customary methods of achieving a substantially constant magnetic field is to operate the superconducting magnet of an MRI system in a "Persistent Mode," in which mode the current circulates, almost perpetually, without applying further power, through a substantially zero-resistance closed-loop set of coils. The advantage of the persistent mode is the constancy of the magnetic field, which is better than what can be achieved in a normal, driven, or non-persistent mode of operation (in which mode power is applied to maintain the current), even with the best regulated power supplies. Furthermore, in the persistent mode no additional energy is needed to power the windings and, therefore, the power supply can be turned off.

In an actively shield MRI superconducting electromagnet operating in persistent mode all field coils and shielding coils, as well as the persistent mode switch coil, are connected in series by superconducting electrical joints. The shield coils, however, are connected to the rest of coils such that the sense of the currents (direction of current flow) in the shielding coils are opposite those of the other coils.

To switch the superconducting magnet from the driven mode into the persistent mode, after energizing the magnet, a "Persistent Mode Switch" may be used. For MRI magnet application a persistent mode switch is typically a non-inductive coil, or switch coil, made from special superconducting wires. When the temperature of the switch coil is below its critical superconducting temperature, the coil is in superconducting state with practically zero resistance, and when the temperature of the switch coil is above its critical temperature the switch coil is in normal (non-superconducting) state and has resistance, for example 10 to 1000 ohms. In a typical MRI superconducting magnet a suitable switch coil with proper normal state resistance is connected to the coils of the magnet such that the switch coil and the magnet coils form a closed loop.

For safety reasons, MRI scanners are used and operated within an area where the magnetic field outside of the area is less than 5x10⁻⁴ T (5 Gauss). The area inside of the 5 Gauss line is sometimes called the MRI magnet's 5-Gauss footprint. For reasons of efficiency and installation cost, superconducting magnets used in MRI applications are magnetically shielded to minimize the 5-Gauss footprint. MRI superconducting magnets may be shielded actively or passively. Actively shielded MRI superconducting magnets are often comprised of main field coils that generate the uniform static magnetic field of higher than 1 T in the area of the geometric center of the magnet systems. Another one or more shielding coils are deployed on the outside of and enclosing or surrounding the field coils to reduce the magnetic footprint of the overall magnetic system by reducing the distance from the core of the machine at which the magnetic field drops to 5x10⁻⁴ T (5 Gauss) or less. The sense or direction of the electrical current in the shielding coils is opposite to the sense of the current in the field coils to induce a magnetic field that reduces or cancels the magnetic field created by the static field outside the MRI scanner. Passively shielded MRI magnets have a set of superconducting main coils and ferromagnetic materials placed strategically on the outside of the superconducting magnet to reduce external magnetic field. In various embodiments, shielding of an MRI magnet may be provided by a combination of active coils and passive ferromagnetic materials.

It is noteworthy to recognize that whether an MRI magnet is shielded actively or passively, there is radial space between the field coils and the shielding coils or the ferromagnetic shields.

Often, in actively shielded MRI superconducting magnets, the field coils and shield coils are placed in the same cryogenic vessel (cryostat). While there is radial space between the field coils and the shield coils, magnet designers tend to minimize the radial space so the overall diameter of the cryostat is minimized. The higher the desired magnetic field in the scanning bore of the MRI, the bigger the magnet, and the bigger the magnet diameter, the more difficult to position the other leg comfortably.

In addition to the superconducting magnet, an MRI scanner has a number of other hardware components such as gradient coils, RF coils, and electronics that are not discussed herein. It is the design and the architecture of the superconducting magnet that has the primary impact on patient comfort in an extremities MRI scanner.

FIGURE 1 shows an example arrangement for using a Magnetic Resonance Imaging (MRI) system for medical diagnostics. Typically, a diagnostic arrangement 100 includes a whole body MRI scanner 102 having a scanning bore 104, which is a tunnel-like opening, to accommodate the whole body of a patient 106 lying on a bed 108. The bed 108 slides into the opening 104 to position the appropriate portion of the patient's body within the MRI magnet system to start the scanning process.

It is estimated that more than about seven million wrist, elbow, knee, and ankle MRI scans were performed in the United States in 2010. This category of scans accounts for 24% of the total number of scans performed in 2010, making it the third largest MRI application after head (29%) and spine (25%) scans. Trauma, arthritis, joint and ligament problems are among the main reasons for performing extremity MRI scans.

Conventionally, extremity scans are performed with the use of whole body machines located in hospitals or outpatient clinics. Patients are required to remain motionless in a whole body machine for a considerable amount of time, even though it is solely the knee, wrist, or other extremity that is being scanned. The use of whole body scanners is inevitable in most MRI applications, but, in the case of extremities MRI, a smaller, dedicated extremity scanner could bring benefits to patients and scanner owners. These benefits may be more significant among elderly patients, who may be subject to considerably less discomfort, and among pediatric patients, who would benefit from lower anxiety and from the proximity of their caregivers during the procedure.

Another benefit may be derived for patients and their doctors if such a scanner was a point-of-care-instrument that allowed for more timely diagnosis and for follow-up image evaluations during a patient's appointment at the doctor's office, rather than in a hospital setting.

A further cost and inconvenience associated with large full-body MRI scanners is that their size and weight precludes them from being suitable for small medical clinics, doctor's offices, and other non-hospital settings because of the special cooling, power, and housing requirements for large machines.

Some medical manufacturers have produced extremity-dedicated MRI machines. Most of these products use permanent magnets which operate at lower than 1.0 T, and some use actively shielded superconducting electromagnets that go up to a 1.5T. But the latter may not be regarded as a point-of-care instrument, because it requires maintenance and helium replenishing, and more importantly, it needs appropriate building infrastructure to ventilate a large volume of helium gas in transient conditions. In actively shielded extremities MRI superconducting electromagnets, there has been a desire to minimize the cryostat diameter to allow the non-scanned leg of the patient straddle the MRI scanner when the scanned leg is resting within the scanning bore of the scanner, positioned at a reasonably comfortable orientation (see FIGURE 2). Some of such scanners, currently on the market, also do not realistically allow for the scanning of both of the patient's knees, one at a time, meaning the right (or left) knee because, as shown in FIGURE 2, the MRI scanning tunnel is asymmetrically located closer to one edge of the machine than the other and there is no place to easily and realistically rest the left leg during the scan, unless the patient is capable of extraordinary flexibility.

A more compact and affordable multi-bore 1.5 T or more extremity MRI scanner, that may use a CF superconducting electromagnet, as disclosed herein, provides significant benefits and advantages to patients, doctors, and equipment owners, especially as a more realistic point-of-care instrument that allows for the scanning of the joints like knee, based on a cryogen-free, and low maintenance magnet, without the need for special facilities or construction.

Additionally, the conventional full-body MRI scanner 102, that generally uses liquid helium, is large, heavy, and expensive, and requires special and extensive construction and facilities including ventilation, plumbing, and safety precautions. Such MRI machines, due to their size and weight, cannot be easily moved through buildings corridors, hallways, doorways, stairways, elevators, and the like to reach its final destination and be installed. In some cases, large cranes are used on the outside a medical building, such as a hospital or a clinic, to lift whole body scanners and position them near the installation room. Then sections of walls and/or windows must be temporarily removed to move the scanner inside the building and then replace the wall or window afterwards. Such moving requirements result in major expenses and inconveniences for the installation. And if the scanner needs to be moved to a different location, all of these processes need to be repeated further adding to the overall cost of operation and ownership. Such considerations are all but absent from a smaller point-of-care machine as disclosed below.

FIGURE 2 shows an example arrangement for using an extremities MRI system for medical diagnostics usable with head and limbs for some patients. Typically, a diagnostic arrangement 200 includes an Extremity MRI (EMRI) scanner 202 having a scanning bore 204 to accommodate an extremity, such as an arm or a leg of a patient 206 sitting down or lying on a chair 208. The chair 208 is configured to allow the patient's limbs to be in close proximity to the opening 204, shown on the front side of the machine, to position the appropriate extremity of the patient within the MRI magnet to start the scanning process. For small patients, such as infants whose size of head and shoulders are close allowing the shoulder to through the scanning bore, it may be possible to use the extremities MRI system for scanning the head and neck.

In some scanners, the scanning bore is placed close to one side of the MRI scanner 202 at least in part to allow one leg to be placed within the scanning bore while the other leg is placed on the side of the scanner to which the bore is closest. However, this arrangement is not symmetrical and thus does not equally accommodate the patient if his legs were switched on the front side of the machine. For example, in FIGURE 2, if the patient's left leg is being scanned, his right leg may be placed on the right side of the scanner to which the bore 204 is closest. But if his right leg is being scanned, then the left leg will have to be pressed against the body of the scanner 202, resulting in a less comfortable experience for the patient. Additionally, moving the patient to the back side of the machine to insert his other leg from the other side of the scanning bore may also not work because the scanning bore is sometimes made to slope downwards with respect to the patient for comfort, thus precluding inserting a leg from the opposite (back) side of the scanning bore to accommodate scanning the other leg. Furthermore, the back of the machine is cluttered with wires, cables, plumbing, attachments, and other peripheral equipment further precluding inserting limbs from the back side of the machine.

Additionally, The EMRI 202, even though smaller than the whole body MRI shown in FIGURE 1, may still use liquid helium often needing special facilities for installation and use. And for installation, at least some of the expense and inconveniences associated with full body scanners, as described above, apply to EMRI machines currently on the market.

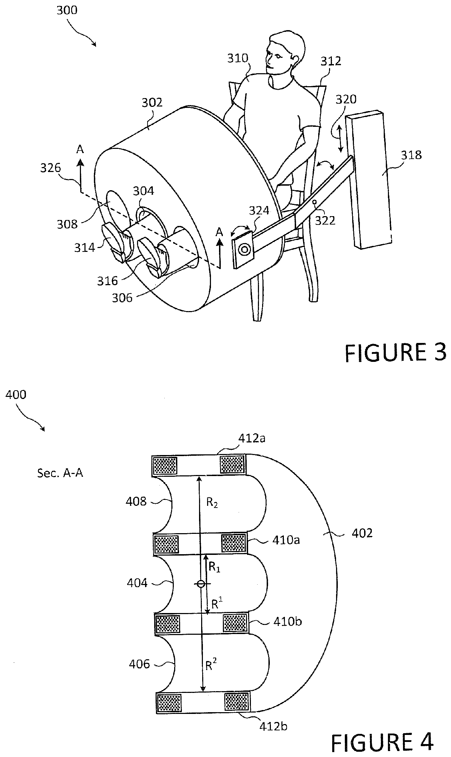

FIGURE 3 shows an example arrangement for using a multi-bore extremities MRI system for medical diagnostics usable with head and limb of a broader group of patients than the scanner shown in FIGURE 2. In various embodiments, diagnostic arrangement 300 includes EMRI scanner body 302 having a scanning bore 304 through which limb 314 of patient 310 sitting on chair 312 passes, and two non-scanning comfort bores 306 and 308 on either side of the scanning bore 304, through which the other non-scanned leg 316 passes. In various embodiments, scanner 302 may be attached to an articulating arm 322 attached at a pivot point 324 at one end and to a rigid structure 318 at the other end for support. The articulating arm may provide sufficient degrees of freedom for desired placement of the scanner with respect to the patient, as signified by arrows 320 and other curved arrows indicating rotational motion of the articulating arm.

In various embodiments, the scanning bore and the extra non-scanning bores may have cross sections which are circular, oval, or any other appropriate and useful geometric shape. A centerline of the extra bores may or may not be parallel to the centerline of the scanning bore. In some embodiments, one or more of the scanning and non-scanning bores may slant downward to provide better ergonomics and comfort for the patient. The bore cross sections and angles of downward slants may be the same or different in various bores in various embodiments.

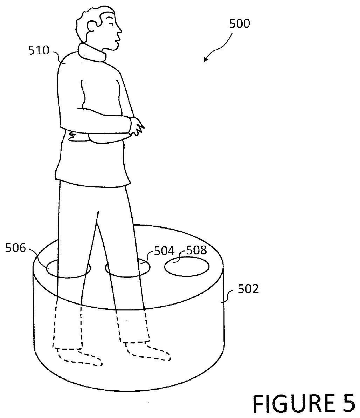

In various embodiments, a suitable magnet for creating the static magnetic field in EMRI scanner may be a Cryogen Free (CF) superconducting magnet. Notwithstanding the benefits of installation and overall economy, a CF superconducting magnet offers the option of operating in various tilt orientations of the scanner, including the option where the central scanning bore is vertical. In this case, scanning may be done on a patient in the standing position where parts like knees are bearing weight, as further described with respect to FIGURE 5 below. While a CF magnet is preferred, a superconducting magnet that uses liquid helium for cooling may be designed and manufactured to include some of the new features disclosed herein. In various embodiments, cryocooler may be implemented using any refrigeration technique that can provide cryogenic temperatures, typically below 150 Kelvin ("K"). ThermoElectric Coolers (TEC) may be used as part of the refrigeration system. TECs, also known as Peltier coolers, are solid-state heat pumps that operate based on the Peltier effect to move heat and can create a differential temperature of up to 70° centigrade or more. The temperatures reached by a refrigeration system depend largely on material such as the refrigeration gas used, solid state junctions in TECs, and the like. Other cryogenic refrigeration systems include Gifford-Mac Mahan type systems and pulse tubes.

In various embodiments, Superconducting magnets that utilize low temperature superconductors, for example Nb-Ti and Nb₃Sn, operate at very low temperatures of 3-15 K. One method of cooling down such a superconducting magnet to these very low temperatures is by using a two-stage cryocooler (also known as a cryo-refrigerator) that makes physical contact with designated parts of the magnet system thereby extracting heat by way of conduction through the connected parts. This method of cooling is commonly referred to as being cryogen free, or conduction cooling. In these embodiments, various components of the cryostat may operate in vacuum.

The amount of cooling (removal of heat) that is provided by a two stage cryocooler can be a few tens of watts for the first stage achieving for example a temperature of 30-60K and a few watts for the second stage achieving 3-6K. Therefore the amount of heat transferred (also known as heat leak) to the superconducting magnet from the environment must be reduced to or be lower than the cooling capacity of the cryocooler.

Heat transfer to a superconducting magnet is by way of convection, radiation and conduction. In the case of a cryogen-free superconducting magnet, convection heat transfer is reduced by housing the superconducting magnet inside a vacuum chamber (vessel), which in this case is referred to as the cryostat. Radiation heat transfer may be reduced by housing the superconducting magnet inside a radiation shield, which in turn may be housed within the vacuum chamber. This radiation shield is cooled by the first stage of the two-stage cryocooler to a temperature of 30-60K, and is generally covered on the side facing the vacuum chamber with several layers of reflective insulation, often referred as super-insulation. Conduction heat transfer may also be reduced by proper material selection and strategic placement of such low-heat conductivity material.

Integrating a cryocooler in a conduction cooled (cryogen-free) device with the EMRI machine, and using it instead of liquid helium, liquid nitrogen, or other cryogens to cool the coils for superconductivity, allows the size, cost, and complexity of the EMRI machine and its installation to be reduced. Additionally, using CF magnets enables and allows various rotations and movements of the EMRI machine as further described below. According to the invention the one or more non-scanning bores is/are deployed in the space between the shielding magnetic coils and the scanning or main magnetic coils, as further described with respect to FIGURE 4 below.

In some embodiments, a single extra non-scanning bore may be provided in the EMRI to accommodate the non-scanned leg, such as EMRI machine 302 with only bore 306. In such a case, the scanned leg 314 may be placed in the center scanning bore 304, while the other leg 316 may be rested in the single extra bore 306. If the legs are exchanged, then the EMRI scanner's body may be rotated an angular amount, such as 180°, around the longitudinal centerline or axis of the scanning bore (parallel to the patient's scanned leg), or around the vertical axis of the EMRI machine 302 (an axis which is perpendicular to the longitudinal centerline or axis of the scanning bore 304)to accommodate the other leg. In other embodiments, chair 312 or an extra chair may be placed on the opposite side of EMRI machine 302 for the patient 310 to sit and scan leg 316 in the scanning bore 304, while resting leg 314 in extra bore 306.

In other embodiments, two extra non-scanning bore may be provided to avoid having to rotate the EMRI machine, as described above.

In various embodiments, the articulating support and positioning arm 322 may be attached to a rigid post fastened to the floor, while in other embodiments, the articulating arm may attached to the ceiling. For complete freedom of positioning and rotating the EMRI machine in 3D space, several, for example seven, degrees of freedom may be needed in the arm and/or its attachment point to the EMRI machine. However, if all possible types of rotation or positioning are not needed, then a simpler articulating arm providing only the needed motions for the EMRI machine may be used. For example, if two side bores (non-scanning) are provided, then there may be no need for the ability to rotate the EMRI machine around its center bore's axis and one degree of freedom may be thus eliminated to reduce costs and also simplify the system.

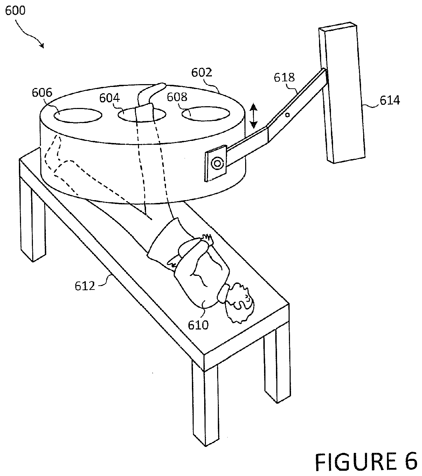

Such articulating arm supporting the EMRI machine allows easily positioning it in various positions and orientations as needed by the medical staff at the point and time of usage, without altering the installation of the EMRI machine or other undue and burdensome efforts, to best serve the patient. The position is defined as a point in the volume reachable by the arm, while the orientation is the angle of the longitudinal centerline through the tunnel-like or cylindrical scanning bore of the EMRI device with respect to a particular reference frame, such as that defined by the rigid structure 318 as the origin of the reference frame. For example, in some diagnostic scenarios, the patient may need to place his weight on his leg during scanning to see how his weight affects his knee joint and/or the soft tissue surrounding the joint. In other scenarios, the patient may need to be seated or lying down for the scan. These scenarios are further described with respect to FIGURES 5 and 6 below.

In various embodiments, the center bore and the side bores may be better understood when viewed looking into cross-section A-A 326 taken from the EMRI machine 302.

FIGURE 4 shows cross-Section A-A of the example arrangement for using a multi-bore extremities MRI system of FIGURE 3. In various embodiments, perspective cross-section A-A 400, corresponding to cross-section A-A 326 of FIGURE 3, may reveal the internal physical relationship between the scanning coils which generate the powerful scanning and static magnetic field within the scanning bore, the shielding coils which reduce the 5-Gauss footprint for the EMRI machine, and the scanning and non-scanning bores within the EMRI machine. In various embodiments, the body 402 of the EMRI machine may include a scanning bore 404 and two side non-scanning bores 406 and 408 deployed between the scanning or main coils' cross sections 410a and 410b, and the shielding coils' cross sections 412a and 412b. The small dots shown arranged in rectangular formations in the various coils signify cross section of coil wires in some embodiments. Even though in FIGURE 4 the cross sections of single coils are shown for each of the main coils and the shielding coils, in practical embodiments, multiple magnetic coils may be deployed for implementing one or more of the electromagnets.

In various embodiments, the center bore coil configured to generate the static powerful magnetic field for aligning the protons in body tissues has a radius of R₁ measured from the center of the scanning bore 404, as shown. The cut-away cross-section A-A shows one end of the cross section of wires within the scanning coil 410a continuing to the other end of the cross section 410b. Similarly, the shielding coil configured to generate the static shielding magnetic field, which when combined with the static field (generated bby the main/field coil) creates a resultant magnetic field with a reduced size 5-Gauss footprint, has a radius of R₂ measured from the center of the scanning bore 404, as shown. The cut-away cross-section A-A shows one end of the cross section of wires within the shielding coil 412a continuing to the other end of the cross section 412b.

Between these two sets of coils, namely, the main (or scanning, or field) coils and the shielding coils, the difference between R₁ and R₂ provides a space for deploying the side bores 406 and 408, as shown.

In various embodiments, gradient coils, as well as RF coils, are also deployed within the scanning bore around the patent's extremity to affect the scanning, as described above.

In various embodiments, the EMRI magnetic shield may be active as described above, or be passive using a natural or permanent magnet. In other embodiments, the magnetic shield may be a combination of passive and active magnets. In such configurations, the shield may be optimized to reduce the 5-Gauss footprint, and reduce cost and size of the EMRI. In various embodiments, the EMRI system may have a passively shielded superconducting magnet, using a ferro-magnet, in which the other (non-scanned) leg may be placed between the outside of the cryostat of the superconducting magnet and the ferromagnetic shield. This resting place may be an open annular space or a bore.

FIGURE 5 shows an example application of the multi-bore extremities MRI system of FIGURE 3 in a standing or vertical position. In various embodiments, diagnostic arrangement 500 includes patient 510 standing up in a vertical position with one leg passing through the center scanning bore 504 and the other leg in one of the non-scanning side bores 506 and 508 deployed within the EMRI scanner 502.

In various embodiments, the EMRI scanner may be placed near the floor permanently for vertical scanning or be attached to an articulating arm, as shown in FIGURE 3, and be positioned for vertical scanning. The patient may also sit above the EMRI scanner with legs hanging down into the scanning bore for scanning ankles or other lower areas of the leg.FIGURE 6 shows an example application of the multi-bore extremities MRI system of FIGURE 3 in a lying down or horizontal position. In various embodiments, diagnostic arrangement 600 includes patient 610 lying down on a bed 612 in a horizontal position with one leg passing up through the center scanning bore 604 and the other leg in one of the non-scanning side bores 606 and 608 deployed within the EMRI scanner 602. An articulating arm 618 attached to a rigid support 614 may be attached to support and position the EMRI scanner.

In various embodiments, the EMRI scanner may be placed hanging down near the ceiling permanently for vertical scanning of patient's leg while lying down or be attached to an articulating arm 618, as shown, and be positioned for vertical scanning. The patient may also sit down below the EMRI scanner with arms raised up into the scanning bore for scanning wrists, elbows, or other lower areas of the arm in a raised position. Similarly the head and neck areas may be scanned while the patient is sitting upright.

Various patient positions may bear on the physiological or physical states of his body. Thus, there may be a most suitable position of a patient for obtaining a best diagnosis. For example, scanning while standing up in a weight bearing position may reveal details and injuries and that sitting down without the force of body weight may not reveal. Similarly, with the head upright in a sitting position, the scan may reveal circulatory problems while blood is being pumped up by the heart that may not be revealed as well if the patient is lying down.

Changes can be made to the claimed invention in light of the above Detailed Description. While the above description details certain embodiments of the invention and describes the best mode contemplated, no matter how detailed the above appears in text, the claimed invention can be practiced in many ways. Details of the system may vary considerably in its implementation details, while still being encompassed by the claimed invention disclosed herein.

Particular terminology used when describing certain features or aspects of the invention should not be taken to imply that the terminology is being redefined herein to be restricted to any specific characteristics, features, or aspects of the invention with which that terminology is associated. In general, the terms used in the following claims should not be construed to limit the claimed invention to the specific embodiments disclosed in the specification, unless the above Detailed Description section explicitly defines such terms.

## Claims

1. An Extremities Magnetic Resonance Imaging (EMRI) device comprising:
a device body having a central scanning bore (304; 404; 504; 604) configured to receive a body extremity to be scanned, and a superconducting field magnet surrounding the scanning bore,
**characterized in that**
the device body contains a side non-scanning bore (306, 308; 406, 408; 506, 508; 606, 608), wherein the central scanning bore (304; 404; 504; 604) and the side non-scanning bore (306, 308; 406, 408; 506, 508; 606, 608) are physically separate and isolated from each other and do not enclose any common space;
and **in that** the EMRI device contains a shield magnet surrounding the superconducting field magnet, the central scanning bore (304; 404; 504; 604), and the side non-scanning bore (306, 308; 406, 408; 506, 508; 606, 608), wherein the side non-scanning bore (306, 308; 406, 408; 506, 508; 606, 608) is deployed between the superconducting field magnet and the shield magnet and is configured to receive a body extremity not to be scanned.

2. The device of claim 1, further containing a cryocooler, and wherein the shield magnet is a superconducting coil and wherein the superconducting field magnet and the superconducting shield coil operate in a cryogen-free magnet system and the cryocooler is configured to cool the superconducting field magnet and the superconducting shield coil by conduction.

3. The device of claim 1, further comprising an articulating arm (322; 618) configured to position the device body in a desired three-dimensional space and in a desired orientation.

4. The device of claim 1, wherein the superconducting field magnet, and the shield magnet are configured to produce a stable and constant magnetic field.

5. The device of claim 2, wherein coils of the field and the shield superconducting magnets are connected in series and operate in persistent mode.

6. The device of claim 4, wherein the device has two side non-scanning bores (306, 308; 406, 408; 506, 508; 606, 608), one on either side of the central scanning bore (304; 404; 504; 604), both side non-scanning bores are deployed between the field magnet and the shield magnet.

7. The device of claim 1, wherein the side non-scanning bore (306, 308; 406, 408; 506, 508; 606, 608) is not parallel to the central scanning bore (304; 404; 504; 604).

8. A method of scanning body extremities, the method comprising:
using an Extremities Magnetic Resonance Imaging (EMRI) device having at least two bores including a central scanning bore (304; 404; 504; 604) and a side non-scanning bore (306, 308; 406, 408; 506, 508; 606, 608), wherein the central scanning bore (304; 404; 504; 604) and the side non-scanning bore (306, 308; 406, 408; 506, 508; 606, 608) are physically separate and isolated from each other and do not enclose any common space, wherein the side non-scanning bore (306, 308; 406, 408; 506, 508; 606, 608) is configured to receive a non-scanned body extremity, and wherein the side non-scanning bore (306, 308; 406, 408; 506, 508; 606, 608) is deployed between a superconducting field magnet and a shield magnet surrounding the central scanning bore (304; 404; 504; 604);
placing a body extremity to be scanned in the central scanning bore (304; 404; 504; 604);
placing another body extremity not to be scanned in the side non-scanning bore (306, 308; 406, 408; 506, 508; 606, 608); and
scanning the body extremity to be scanned.

9. The method of claim 8, wherein the EMRI device has two side non-scanning bores (306, 308; 406, 408; 506, 508; 606, 608), one on either side of the central scanning bore (304; 404; 504, 604), both side non-scanning bores (306, 308; 406, 408; 506, 508; 606, 608) deployed between the field magnet and the shield magnet.

10. The method of claim 8, wherein the shield magnet is a cryogen-free superconducting magnet.

11. The method of claim 8, wherein the superconducting field magnet and the shield magnet are configured to produce a stable and constant magnetic field.

12. The method of claim 11, wherein coils of the field and shield superconducting magnets are connected in series and operate in persistent mode.

13. The method of claim 8, wherein the central scanning bore (304; 404; 504; 604) and the side non-scanning bore (306, 308; 406, 408; 506, 508; 606, 608) are slanted down for further comfort of a patient being scanned by the EMRI.

## Patentansprüche

1. Eine Extremitätenmagnetresonanztomographie (EMRI)-Vorrichtung umfassend:
ein Vorrichtungsgehäuse aufweisend eine zentrale Abtastbohrung (304; 404; 504; 604), die derart gestaltet ist, dass sie eine abzutastende Körperextremität aufnimmt, und
einen supraleitenden Feldmagneten, der die Abtastbohrung umgibt,
**dadurch gekennzeichnet, dass**
das Vorrichtungsgehäuse eine seitliche nicht-Abtastbohrung (306, 308; 406, 408; 506, 508; 606, 608) aufweist, wobei die zentrale Abtastbohrung (304; 404; 504; 604) und die seitliche Nicht-Abtastbohrung (306, 308; 406, 408; 506, 508; 606, 608) physisch getrennt und voneinander isoliert sind, und keinerlei gemeinsamen Raum umschließen;
und dass die EMRI-Vorrichtung einen Schildmagneten aufweist, der den supraleitenden Feldmagneten, die zentrale Abtastbohrung (304; 404; 504; 604) und die seitliche Nicht-Abtastbohrung (306, 308; 406, 408; 506, 508; 606, 608) umgibt, wobei die seitliche Nicht-Abtastbohrung (306, 308; 406, 408; 506, 508; 606, 608) zwischen dem supraleitenden Feldmagneten und dem Schildmagneten angeordnet und derart gestaltet ist, dass sie eine nicht abzutastende Körperextremität aufnimmt.

2. Vorrichtung nach Anspruch 1, ferner aufweisend einen Kryokühler, und wobei der Schildmagnet eine supraleitende Spule ist, und wobei der supraleitende Feldmagnet und die supraleitende Schildspule in einem kryogenfreien Magnetsystem wirken, und der Kryokühler derart gestaltet ist, dass er den supraleitenden Feldmagneten und die supraleitende Schildspule durch Konduktion kühlt.

3. Vorrichtung nach Anspruch 1, ferner aufweisend einen Gelenkarm (322; 618), der derart gestaltet ist, dass er das Vorrichtungsgehäuse in einem gewünschten dreidimensionalen Raum und in einer gewünschten Ausrichtung anordnet.

4. Vorrichtung nach Anspruch 1, wobei der supraleitende Feldmagnet und der Schildmagnet derart gestaltet sind, dass sie ein stabiles und konstantes Magnetfeld erzeugen.

5. Vorrichtung nach Anspruch 2, wobei Spulen der supraleitenden Feld-und Schildmagneten in Reihe geschaltet sind und im Dauermodus wirken.

6. Vorrichtung nach Anspruch 4, wobei die Vorrichtung zwei Nicht-Abtastbohrungen (306, 308; 406, 408; 506, 508; 606, 608), eine auf jeder Seite der zentralen Abtastbohrung (304; 404; 504; 604), aufweist, wobei beide seitlichen Nicht-Abtastbohrungen zwischen dem Feldmagneten und dem Schildmagneten angeordnet sind.

7. Vorrichtung nach Anspruch 1, wobei die seitliche Nicht-Abtastbohrung (306, 308; 406, 408; 506, 508; 606, 608) nicht parallel zur zentralen Abtastbohrung (304; 404; 504; 604) angeordnet ist.

8. Verfahren zum Abtasten von Körperextremitäten, das Verfahren umfassend:
das Verwenden einer Extremitätenmagnetresonanztomographie (EMRI)-Vorrichtung, die mindestens zwei Bohrungen aufweist, welche eine zentrale Abtastbohrung (304; 404; 504; 604) und eine seitliche Nicht-Abtastbohrung (306, 308; 406, 408; 506, 508; 606, 608) umfassen, wobei die zentrale Abtastbohrung (304; 404; 504; 604) und die seitliche Nicht-Abtastbohrung (306, 308; 406, 408; 506, 508; 606, 608) physisch getrennt und voneinander isoliert sind, und keinerlei gemeinsamen Raum umschließen, wobei die seitliche Nicht-Abtastbohrung (306, 308; 406, 408; 506, 508; 606, 608) derart gestaltet ist, dass sie eine nicht abgetastete Körperextremität aufnimmt, und wobei die seitliche Nicht-Abtastbohrung (306, 308; 406, 408; 506, 508; 606, 608) zwischen einem supraleitenden Feldmagneten und einem Schildmagneten, welche die zentrale Abtastbohrung (304; 404; 504; 604) umgeben, angeordnet ist;
das Platzieren einer abzutastenden Körperextremität in der zentralen Abtastbohrung (304; 404; 504; 604);
das Platzieren einer anderen, nicht abzutastenden Körperextremität in der seitlichen Nicht-Abtastbohrung (306, 308; 406, 408; 506, 508; 606, 608); und
das Abtasten der abzutastenden Körperextremität.

9. Verfahren nach Anspruch 8, wobei die EMRI-Vorrichtung zwei Nicht-Abtastbohrungen (306, 308; 406, 408; 506, 508; 606, 608), eine auf jeder Seite der zentralen Abtastbohrung (304; 404; 504; 604), aufweist, wobei beide seitlichen Nicht-Abtastbohrungen (306, 308; 406, 408; 506, 508; 606, 608) zwischen dem Feldmagneten und dem Schildmagneten angeordnet sind.

10. Verfahren nach Anspruch 8, wobei der Schildmagnet ein kryogenfreier, supraleitender Magnet ist.

11. Verfahren nach Anspruch 8, wobei der supraleitende Feldmagnet und der Schildmagnet derart gestaltet sind, dass sie ein stabiles und konstantes Magnetfeld erzeugen.

12. Verfahren nach Anspruch 11, wobei Spulen der supraleitenden Feld-und Schildmagneten in Reihe geschaltet sind und im Dauermodus wirken.

13. Verfahren nach Anspruch 8, wobei die zentrale Abtastbohrung (304; 404; 504; 604) und die seitliche Nicht-Abtastbohrung (306, 308; 406, 408; 506, 508; 606, 608) für noch größeren Komfort eines Patienten, der mittels EMRI abgetastet werden soll, nach unten geneigt sind.

## Revendications

1. Dispositif d'imagerie à résonance magnétique d'extrémités (EMRI) comprenant :
un corps de dispositif ayant un alésage de balayage central (304 ; 404 ; 504 ; 604) configuré pour recevoir une extrémité de corps à balayer et un élément à champ supraconducteur entourant l'alésage de balayage, **caractérisé en ce que** le corps de dispositif contient un alésage de non balayage latéral (306, 308 ; 406, 408 ; 506, 508 ; 606, 608), dans lequel l'alésage de balayage central (304 ; 404 ; 504 ; 604) et l'alésage de non balayage latéral (306, 308 ; 406, 408 ; 506, 508 ; 606, 608) sont physiquement séparés et isolés l'un de l'autre et ne renferment aucun espace commun ;
et **en ce que** le dispositif EMRI contient un élément de blindage entourant un aimant à champ supraconducteur, l'alésage de balayage central (304 ; 404 ; 504 ; 604) entourant l'aimant à champ supraconducteur, l'alésage de balayage central (306, 308 ; 406, 408 ; 506, 508 ; 606, 608) et l'alésage de non balayage latéral (306, 308 ; 406, 408 ; 506, 508 ; 606, 608) est déployé entre l'aimant à champ supraconducteur et l'aimant de blindage et est configuré pour recevoir une extrémité de corps à ne pas balayer.

2. Dispositif selon la revendication 1, contenant en outre un réfrigérateur cryogénique et dans lequel l'aimant de blindage est un enroulement supraconducteur et dans lequel l'aimant à champ supraconducteur et l'enroulement de blindage supraconducteur fonctionnent dans un système d'aimant sans cryogène et le réfrigérateur cryogénique est configuré pour refroidir l'aimant à champ supraconducteur et l'enroulement de blindage supraconducteur par conduction.

3. Dispositif selon la revendication 1, comprenant en outre un bras d'articulation (322 ; 618) configuré pour positionner le corps de dispositif dans un espace tridimensionnel désiré et dans une orientation désirée.

4. Dispositif selon la revendication 1, dans lequel l'aimant à champ supraconducteur et l'aimant de blindage sont configurés pour produire un champ magnétique stable et constant.

5. Dispositif selon la revendication 2, dans lequel les enroulements des aimants à champ supraconducteur et de blindage sont connectés en série et fonctionnent en mode persistant.

6. Dispositif selon la revendication 4, dans lequel le dispositif possède deux alésages de non balayage latéraux (306, 308 ; 406, 408 ; 506, 508 ; 606, 608), un sur l'un et l'autre côté de l'alésage de balayage central (304 ; 404 :504 ; 604), les deux alésages de non balayage non latéraux sont déployés entre l'aimant à champ et l'aimant de blindage.

7. Dispositif selon la revendication 1, dans lequel l'alésage de non balayage latéral (306, 308 ; 406, 408 ; 506, 508 ; 606, 608) n'est pas parallèle à l'alésage de balayage central (304 ; 404 ; 504 ; 604).

8. Procédé de balayage d'extrémités de corps, le procédé comprenant de :
utiliser un dispositif d'imagerie à résonance magnétique d'extrémités (EMRI) ayant au moins deux alésages incluant un alésage de balayage central (304 ; 404 ; 504 ; 604) et un alésage de non balayage latéral (306, 308 ; 406, 408 ; 506, 508 ; 606, 608), dans lequel l'alésage de balayage central (304 ; 404 ; 504 ; 604) et l'alésage de non balayage latéral (306, 308 ; 406, 408 ; 506, 508 ; 606, 608) sont physiquement séparés et isolés l'un de l'autre et ne renferment aucun espace commun, dans lequel l'alésage de non balayage latéral (306, 308 ; 406, 408 ; 506, 508 ; 606, 608) est configuré pour recevoir une extrémité de corps non balayée, et dans lequel l'alésage de non balayage latéral (306, 308 ; 406, 408 ; 506, 508 ; 606, 608) est déployé entre un aimant à champ supraconducteur et un aimant de blindage entourant l'alésage de balayage central (304 ; 404 ; 504 ; 604) ;
placer une extrémité de corps à balayer dans l'alésage de balayage central (304 ; 404 ; 504 ; 604) ;
placer une autre extrémité de corps à ne pas balayer dans l'alésage de non balayage latéral (306, 308 ; 406, 408 ; 506, 508 ; 606, 608) ; et
balayer l'extrémité de corps à balayer.

9. Procédé selon la revendication 8, dans lequel le dispositif EMRI a deux alésages de non balayage latéral (306, 308 ; 406, 408 ; 506, 508 ; 606, 608), un sur l'un et l'autre côté de l'alésage de balayage central (304 ; 404 :504 ; 604), les deux alésages de non balayage non latéraux (306, 308 ; 406, 408 ; 506, 508 ; 606, 608), étant déployés entre l'aimant à champ et l'aimant de blindage.

10. Procédé selon la revendication 8, dans lequel l'aimant de blindage est un aimant supraconducteur sans cryogène.

11. Procédé selon la revendication 8, dans lequel l'aimant à champ supraconducteur et l'aimant à blindage sont configurés pour produire un champ magnétique stable et constant.

12. Procédé selon la revendication 11, dans lequel les enroulements des aimants à champ supraconducteur et de blindage sont connectés en série et fonctionnent en mode persistant.

13. Procédé selon la revendication 8, dans lequel l'alésage de balayage central (304 ; 404 ; 504 ; 604) et l'alésage de non balayage latéral (306, 308 ; 406, 408 ; 506, 508 ; 606, 608) sont inclinés vers le bas pour augmenter le confort d'un patient étant balayé par l'EMRI.
